# EUROPÄISCHE PATENTANMELDUNG

(11) **EP 1 793 232 A2**
(43) Veröffentlichungstag der Anmeldung: **06.06.2007**
(21) Anmeldenummer: 06024900.0
(22) Anmeldetag: 01.12.2006
(51) Int. Cl.: G01R 1/073

(54) **Elektrische Kontakteinrichtung und Prüfvorrichtung für die Prüfung eines elektrischen Prüflings**

(30) Priorität: 05.12.2005 DE 102005058762; 21.11.2006 DE 102006054735
(71) Anmelder: Feinmetall GmbH, 71083 Herrenberg (DE)
(72) Erfinder: Böhm, Gunther, 71154 Nufringen (DE)
(74) Vertreter: Grosse, Rainer

(57) **Zusammenfassung**

Die Erfindung betrifft eine elektrische Kontakteinrichtung (3) für einen elektrischen Prüfling, mit Prüfkontakten (7) zur elektrischen Berührungskontaktierung des Prüflings und mit einer Abstützvorrichtung (14), der ein Zwischenbauteil (30) zum Halten der Kontakteinrichtung (3) in einer Prüfmaschine (2) (Prober) zuordenbar ist. Es ist vorgesehen, dass zur Ausbildung einer permanenten Moduleinheit (32) die Abstützvorrichtung (14) mit einem eigenen, nur dieser Kontakteinrichtung (3) zugehörigen Zwischenbauteil (30) verbunden ist. Ferner betrifft die Erfindung eine elektrische Prüfvorrichtung (1) mit elektrischer Kontakteinrichtung (3).

## Beschreibung

Die Erfindung betrifft eine elektrische Kontakteinrichtung für einen elektrischen Prüfling, mit Prüfkontakten zur elektrischen Berührungskontaktierung des Prüflings und mit einer Abstützvorrichtung, der ein Zwischenbauteil zum Halten der Kontakteinrichtung in einer Prüfmaschine (Prober) zuordenbar ist.

Elektrische Kontakteinrichtungen der eingangs genannten Art dienen der elektrischen Prüfung eines elektrischen Prüflings, beispielsweise eines Wafers. Für die elektrische Prüfung wird die Kontakteinrichtung in eine Prüfmaschine eingesetzt. Die Kontakteinrichtung besitzt eine Vielzahl von Prüfkontakten, die beispielsweise als Knicknadeln ausgebildet sind. Die freien Enden der Knicknadeln dienen der Berührungskontaktierung des Prüflings. Die Prüfmaschine hat die Aufgabe, den Prüfling so unterhalb der Kontakteinrichtung zu positionieren (X- und Y-Ausrichtung) und den Prüfling derart anzuheben (Z-Ausrichtung), dass die Knicknadeln mit entsprechenden Kontakten des Prüflings für die Prüfung berührungskontaktieren. Ferner hat die Prüfmaschine die Aufgabe, elektrische Verbindungen zwischen der Kontakteinrichtung und einem Tester herzustellen. Mittels des Testers wird die elektrische Prüfung des Prüflings durchgeführt, das heißt, es werden elektrische Prüfstromkreise mit dem Prüfling aufgebaut, um eine Funktionsprüfung durchzuführen. Die Prüfstromwege verlaufen vom Tester über die Kontakteinrichtung zum Prüfling und von dort aus zurück zum Tester. Für die Ausrichtung von Kontakteinrichtung und Prüfling werden vorzugsweise Kameras zu Hilfe genommen, die die Lage des Prüflings auf einem so genannten Prüflingsträger (Chuck) der Prüfmaschine (Prober) und die Lage der Nadelspitzen der Knicknadeln sehr präzise (auf wenige µm genau) erfassen und hierdurch eine hinreichend genaue Ausrichtung der Bauteile relativ zueinander ermöglichen, sodass bei einer Kontaktierung die Knicknadeln präzise Kontakt zu den Kontakten des Prüflings erhalten. Meist sind viele Kontaktierungsvorgänge erforderlich, um einen Prüfling, beispielsweise einen Wafer, umfassend auf Funktionsfähigkeit zu prüfen. Für eine einwandfreie Prüfung ist es erforderlich, dass zwischen dem Tester und dem Prüfling kontaktsichere Prüfstromwege ausgebildet werden. Hierzu ist es erforderlich, den Prüfling sehr präzise unterhalb der Kontakteinrichtung zu positionieren und dann mit einer Z-Aufwärtsbewegung mit geeigneter Anpresskraft an die Prüfkontakte der Kontakteinrichtung anzudrücken. Eine Abstützvorrichtung (Stiffener) hat die Aufgabe, die Kräfte, die durch das Anpressen des Prüflings an die Kontakteinrichtung auftreten, sicher und ohne dass unzulässige Verwerfungen und/oder Durchbiegungen auftreten, an die Prüfmaschine abzuleiten. Eine bekannte Prüfmaschine weist hierzu ein als Zwischenring ausgebildetes Zwischenbauteil (Probecard Holder Ring) auf. Dieser, der Prüfmaschine zugeordnete Zwischenring ist in der Prüfmaschine verfahrbar gelagert. Die Prüfmaschine weist an der Front eine Klappe auf, die sich öffnet, wenn der Zwischenring auf einer Art Schublade herausfährt, sodass er mit der Kontakteinrichtung bestückt werden kann. Die vorstehend beschriebene Anordnung entspricht etwa dem Prinzip eines CD-ROM-Laufwerks, dass sich durch Ausfahren einer Schublade öffnet, um eine CD einzulegen. Zur erwähnten Bestückung wird die Kontakteinrichtung in den Zwischenring eingelegt und mit ihm mittels mehrerer, am Umfang verteilter, kleiner Gewindeschrauben verschraubt. Zentrierstifte im Zwischenring und entsprechende Bohrungen in der Kontakteinrichtung ermöglichen dabei eine genaue Ausrichtung der Kontakteinrichtung zum Zwischenring. Nun kann die Prüfmaschine den Zwischenring samt Kontakteinrichtung in ihr Inneres durch Hineinfahren aufnehmen, sodass die Kontakteinrichtung an den für den Test vorgesehenen Ort verschoben wird. Hierbei kann auch ein Rotieren und/oder Anheben erfolgen. Abschließend wird der Zwischenring in der Prüfmaschine arretiert. Auch bei einer Prüfmaschine ohne Schubladen-Be- und Entladung ist ein derartiger Zwischenring vorgesehen, der Bestandteil der Prüfmaschine ist und in ihr stets platziert oder in diese einsetzbar ausgestaltet ist.

Bei relativ großen Kontakteinrichtungen (zum Beispiel Vertikal-Prüfkarten), die eine Vielzahl von Prüfkontakten haben, derzeit mehr als tausend Prüfkontakte (Prüfnadeln), entstehen bei der Kontaktierung vorzugsweise vertikale Kräfte in der Kontakteinrichtung. Je nach Anzahl der Prüfkontakte (Prüfnadeln) können Prüfkräfte zum Beispiel zwischen 10 N und 4000 N auftreten, die von der erwähnten Abstützvorrichtung (Stiffener) aufgenommen und an den Zwischenring weitergegeben und von diesem an die Prüfmaschine übertragen werden. Um eine einwandfreie Funktion des Gesamtsystems zu gewährleisten, ist es erforderlich, die Komponenten Kontakteinrichtung und Zwischenring sehr verwindungssteif aufzubauen, da die der Kontakteinrichtung zugehörigen Prüfkontakte, insbesondere wenn sie als Knicknadeln beziehungsweise Knickdrähte ausgebildet sind, lediglich einen sehr kleinen maximalen Kontakthub (zum Beispiel 50 µm bis zu 200 µm) aufweisen und folglich während der Kontaktierung eine Verwindung und/oder Durchbiegung des Gesamtsystems sehr klein sein muss gegenüber dem genannten maximalen Kontakthub. Will die Prüfmaschine beispielsweise einen Kontakthub von 150 µm einstellen und es liegt eine unzureichende Steifigkeit des Systems vor, sodass zum Beispiel durch Verbiegung ein effektiv an den jeweiligen Prüfkontakten wirksamer Hubkontakt wesentlich kleiner ist, zum Beispiel nur noch 70 µm, so ist eine sichere Kontaktierung des Prüflings nicht gewährleistet.

Der Erfindung liegt daher die Aufgabe zugrunde, eine elektrische Kontakteinrichtung der eingangs genannten Art anzugeben, mit der eine sichere und reproduzierbare Kontaktierung eines Prüflings zu dessen Prüfung möglich ist.

Diese Aufgabe wird erfindungsgemäß dadurch gelöst, dass zur Ausbildung einer permanenten Moduleinheit die Abstützvorrichtung mit einem eigenen, nur dieser Kontakteinrichtung zugehörigen Zwischenbauteil verbunden ist. Demzufolge ist nicht mehr der Prüfmaschine ein einziges Zwischenbauteil, insbesondere Zwischenring, zugeordnet, in den die verschiedenen Kontakteinrichtungen einsetzbar sind, sondern jede Kontakteinrichtung weist ein eigenes Zwischenbauteil auf. Unabhängig davon, ob die Kontakteinrichtung in die Prüfmaschine eingesetzt ist oder nicht, stets besitzt sie ihr eigenes Zwischenbauteil, das optimal mit der Abstützvorrichtung aufgrund individueller Anpassung verbunden ist und daher kein Schnittstellenproblem auftritt, das sich beispielsweise als unzureichende Steifigkeit des Systems bemerkbar machen könnte. Die erwähnte Schnittstelle ist nunmehr nicht bei jedem Einsetzen einer Kontakteinrichtung in die Prüfmaschine herzustellen, sondern sie besteht permanent zwischen der Abstützvorrichtung und dem Zwischenbauteil, da das Zwischenbauteil stets der zugehörigen Kontakteinrichtung zugeordnet ist. Daher muss nicht auf eine stets zu lösende und dann wieder herzustellende Schnittstelle Rücksicht genommen werden, und es lässt sich erfindungsgemäß ein wesentlich steiferer Verbund realisieren.

Nach einer Weiterbildung der Erfindung ist vorgesehen, dass Abstützvorrichtung und Zwischenbauteil zu einem gemeinsamen Bauteil miteinander verbunden sind. Diese Verbindung muss nicht schnittstellenfrei sein, dass heißt, die beiden Teile können miteinander für ihre Verbindung beispielsweise verschraubt sein, jedoch wird diese Verschraubung nicht permanent geöffnet und wieder hergestellt, sondern bei der Herstellung der Kontakteinrichtung werden diese Bauteile verbunden und bleiben dann verbunden, sodass eine hohe Genauigkeit und Präzision vorliegt. Das erwähnte gemeinsame Bauteil kann insbesondere auch durch Verkleben von Abstützvorrichtung und Zwischenbauteil erzeugt werden, wodurch sich ebenfalls eine hoch belastbare und präzise Verbindung schaffen lässt.

Nach einer Weiterbildung der Erfindung ist vorgesehen, dass Abstützvorrichtung und Zwischenbauteil einstückig miteinander verbunden sind. Hierdurch entfällt sogar die erwähnte Schnittstelle, sodass eine sehr steife und hochgenaue Konstruktion vorliegt.

Nach einer Weiterbildung der Erfindung ist vorgesehen, dass die Kontakteinrichtung als Prüfkarte ausgebildet ist. Die Prüfkarte ist vorzugsweise eine Vertikal-Prüfkarte. Dies bedeutet, dass sie in horizontaler Lage vertikal orientierte Prüfkontakte, insbesondere Prüfstifte oder Prüfnadeln, vorzugsweise Knicknadeln beziehungsweise Knickdrähte, aufweist. Diese Prüfkontakte gehören vorzugsweise einem Kontaktkopf an. Mit den Prüfkontakten des Kontaktkopfs wird die elektrische Berührungskontaktierung des Prüflings bei dessen Prüfung durchgeführt.

Nach einer Weiterbildung der Erfindung ist vorgesehen, dass die Abstützvorrichtung eine vordere Abstützung und eine hintere Abstützung aufweist. Die vordere Abstützung befindet sich auf der Seite der Kontakteinrichtung, die dem Prüfling zugekehrt ist. Die hintere Abstützung liegt demzufolge auf der Seite der Kontakteinrichtung, die dem Prüfling abgewandt liegt.

Insbesondere ist vorgesehen, dass die hintere Abstützung zur Ausbildung der permanenten Moduleinheit mit dem Zwischenbauteil verbunden ist. Die vordere Abstützung ist vorzugsweise mit der hinteren Abstützung verbunden.

Zwischen der vorderen Abstützung und der hinteren Abstützung ist bevorzugt ein Verdrahtungsträger, insbesondere eine Leiterplatte, angeordnet. Diese Leiterplatte weist auf ihrer dem Kontaktkopf zugeordneten Seite Kontakte auf, die über entsprechende Leiterbahnen mit Kontakten verbunden sind, die sich auf ihrer Rückseite, also auf der dem Prüfkopf abgewandten Seite befinden. Während die Kontakte auf der Vorderseite des Verdrahtungsträgers sehr eng beieinander liegen und sehr klein ausgestaltet sind, damit die entsprechend eng beieinander liegenden Kontakte des Prüflings über die zwischengestalteten Prüfkontakte kontaktiert werden können, sind die auf der Rückseite des Verdrahtungsträgers angeordneten Kontakte größer und weiter auseinander liegend ausgebildet, sodass problemlos der bereits erwähnte Tester angeschlossen werden kann. Demzufolge dient der Verdrahtungsträger als Umsetzeinrichtung, um einen sehr engen Kontaktabstand auf einen größeren Kontaktabstand umzusetzen.

Ferner ist es vorteilhaft, wenn Kontakte des Verdrahtungsträgers mit den Prüfkontakten des Kontaktkopfs in Berührungskontakt stehen. Hierauf wurde bereits vorstehend eingegangen. Die Prüfkontakte sind somit nicht fest mit den Kontakten des Verdrahtungsträgers verbunden, sondern durch Anlage der sich vorzugsweise vertikal erstreckenden Knicknadeln beziehungsweise Knickdrähte an den Kontakten des Verdrahtungsträgers. Diese Anlage wird durch den Kontaktdruck beim Kontaktieren des Prüflings unterstützt.

Ferner betrifft die Erfindung eine elektrische Prüfvorrichtung für die Prüfung eines elektrischen Prüflings, mit einer Prüfmaschine (Prober), in die jeweils eine der Berührungskontaktierung des Prüflings dienenden Kontakteinrichtung, insbesondere eine wie vorstehend beschrieben, wählbar aus einer Vielzahl von vorzugsweise verschiedenen Kontakteinrichtungen einsetzbar ist, und mit mindestens einem Zwischenbauteil zum Halten der jeweils verwendeten Kontakteinrichtung in der Prüfmaschine, wobei jede Kontakteinrichtung mit einem eigenen Zwischenbauteil zur jeweiligen Ausbildung einer permanenten Moduleinheit ausgestattet ist. Wenn in eine derartige Prüfmaschine somit eine Kontakteinrichtung eingesetzt wird, so weist diese ihr eigenes Zwischenbauteil, insbesondere ihren eigenen Zwischenring, auf, der stets an der Kontakteinrichtung verbleibt, unabhängig davon, ob diese zur Prüfung gerade verwendet wird und sich somit in der Prüfmaschine befindet oder für spätere Einsatzzwecke außerhalb der Prüfmaschine gelagert wird. Demzufolge wird nicht mehr - wie im Stand der Technik - einer Kontakteinrichtung jeweils ein und dasselbe Zwischenbauteil zugeordnet, das der Prüfmaschine angehört und demzufolge nur einmal vorhanden ist, sodass unterschiedliche Kontakteinrichtungen, die der Prüfung unterschiedlicher Prüflinge dienen, stets mit dem gleichen Zwischenbauteil verbunden werden müssen. Hier schafft die Erfindung dadurch Abhilfe, dass so viele Zwischenbauteile vorhanden sind, wie Kontakteinrichtungen vorliegen, das heißt, jede Kontakteinrichtung hat ihr eigenes Zwischenbauteil, sodass jede Kontakteinrichtung mit dem Zwischenbauteil eine permanente Moduleinheit bildet.

Die Zeichnungen veranschaulichen die Erfindung anhand von Ausführungsbeispielen, und zwar zeigt:
- Figur 1: einen Querschnitt durch eine elektrische Prüfvorrichtung für die Prüfung eines elektrischen Prüflings,
- Figur 2: einen Querschnitt durch eine in eine Prüfmaschine der Prüfvorrichtung eingesetzte Kontakteinrichtung zur Kontaktierung des Prüflings und
- Figur 3: ein weiteres Ausführungsbeispiel einer Kontakteinrichtung.

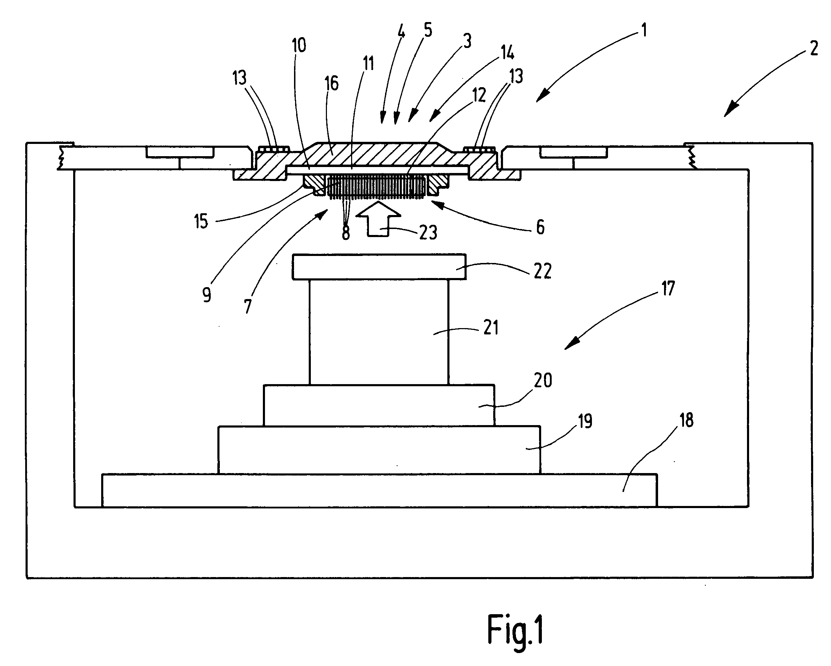

Die Figur 1 zeigt eine elektrische Prüfvorrichtung 1, die der Prüfung eines aus der Figur 1 nicht hervorgehenden Prüflings dient. Die Prüfvorrichtung 1 weist eine Prüfmaschine 2 (Prober) auf, in die eine Kontakteinrichtung 3 eingesetzt ist. Die Kontakteinrichtung 3 wird vorzugsweise mittels einer Schubladenkonstruktion ähnlich der eines CD-ROM-Laufwerks in die Prüfmaschine 2 eingesetzt. Die Kontakteinrichtung 3 ist als Prüfkarte 4, insbesondere Vertikal-Prüfkarte 5, ausgebildet. Letzteres bedeutet, dass sie in einem Kontaktkopf 6 eine Vielzahl von Prüfkontakten 7 aufweist, die als Nadeln, insbesondere Knicknadeln 8, ausgebildet sind, die quer, insbesondere vertikal, zur vorzugsweise horizontalen Prüfebene verlaufen. "Knicknadeln" bedeutet, dass diese jeweils eine leichte Durchbiegung aufweisen, sie also von einer geradlinigen Form abweichen. Die Durchbiegung kann beispielsweise durch versetzt liegende Halteöffnungen einer Führung 9 hervorgerufen werden, in denen die Knicknadeln längsverschieblich lagern. Wird der Prüfling gegen die vorzugsweise spitz auslaufenden freien Enden der Knicknadeln 8 gedrängt, so können diese aufgrund der Durchbiegung leicht ausfedern und hierdurch Abstandsunregelmäßigkeiten ausgleichen und sehr gut kontaktieren.

Wie bereits vorstehend erwähnt, werden die Knicknadeln 8 in der Führung 9 gehalten, wobei die einen Enden der Knicknadeln 8 freie Enden bilden, die dem Berührungskontaktieren des Prüflings dienen. Die anderen Enden der Knicknadeln 8 liegen an Kontakten 12 eines Verdrahtungsträgers 10, vorzugsweise einer Leiterplatte 11, der Kontaktanordnung 3 an. Die erwähnten Kontakte 12 der Leiterplatte 11 sind mit auf der anderen Seite der Leiterplatte 11 liegenden Kontakten 13 verbunden, beispielsweise über Leiterbahnen 41 der Leiterplatte 11. Die Kontakte 13 werden an einen Tester angeschlossen, der in der Figur 1 nicht gezeigt ist und der dazu dient, Prüfstromwege zum Prüfling durchzuschalten, um den Prüfling auf elektrische Funktionsfähigkeit zu prüfen. Während die von den Knicknadeln 8 berührten Kontakte 12 der Leiterplatte 11 extrem eng beieinander liegen, können die Kontakte 13 über eine weitaus größere Fläche verteilt angeordnet werden, sodass der Anschluss des Testers problemlos möglich ist. Zur Versteifung der Kontakteinrichtung 3 ist eine Abstützvorrichtung 14, bestehend aus einer vorderen Abstützung 15 und einer hinteren Abstützung 16 vorgesehen. Die Abstützvorrichtung 14 dient dazu, den Kontaktdruck aufzunehmen, der entsteht, wenn der Prüfling - wie nachstehend noch näher beschrieben werden wird - gegen die Knicknadeln 8 zur Berührungskontaktierung gedrängt wird.

Die Prüfmaschine 2 weist einen Prüflingsträger 17 (Chuck) auf, der eine feststehende Basisplatte 18 besitzt. Ferner gehört zum Prüflingsträger 17 eine Y-Positioniereinrichtung 19, eine X-Positioniereinrichtung 20 und eine Z-Positioniereinrichtung 21. Auf der Z-Positioniereinrichtung 21 ist eine Vakuumhalterung 22 angeordnet, mit der der Prüfling durch Unterdruck positionsunveränderlich gegenüber der Vakuumhalterung 22 gehalten werden kann. Wird nun der Prüfling, beispielsweise ein Wafer, flächig auf die Vakuumhalterung 22 gelegt und durch Unterdruck gehalten, so kann er mittels der X- und Y-Positioniereinrichtungen 20 und 19 und unter Zuhilfenahme von Kameras positionsgenau unterhalb der Kontakteinrichtung 3 derart positioniert werden, dass beim Berührungskontaktieren die Knicknadeln 8 positionsgenau entsprechende Kontakte des Prüflings kontaktieren. Für die Kontaktierung fährt die Z-Positioniereinrichtung 21 nach oben und drängt den Prüfling gegen die freien Enden der Knicknadeln 8. Diese Bewegung ist in der Figur 1 mittels eines Pfeiles 23 angedeutet.

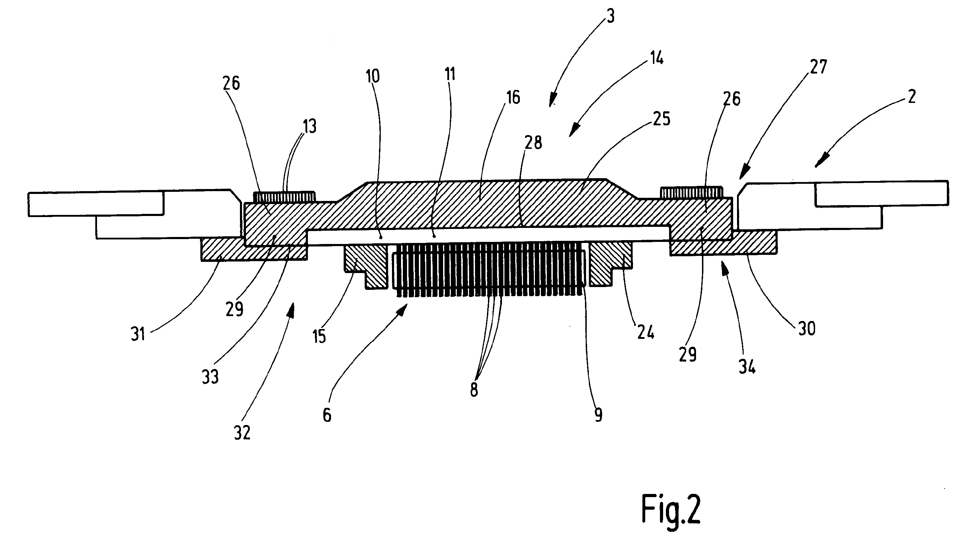

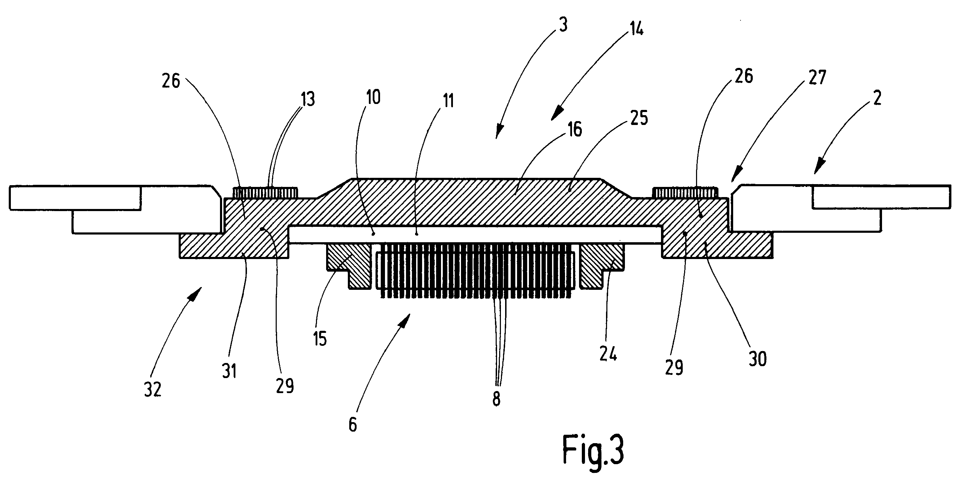

Die Figur 2 zeigt die elektrische Kontakteinrichtung 3 der Figur 1 in vergrößerter Darstellung. Es handelt sich um eine Querschnittsansicht. Grundsätzlich ist davon auszugehen, dass der Verdrahtungsträger 10 als flächiges Bauteil, insbesondere als Kreisscheibe, ausgebildet. Entsprechendes gilt für den Kontaktkopf 6, der vorzugsweise ebenfalls eine kreisscheibenartige Form aufweist. Natürlich sind auch andere Formen des Kontaktkopfes wie beispielsweise rechteckig oder quadratisch scheibenartige Formen denkbar. Die Abstützvorrichtung 14 ist - bei dreidimensionaler Betrachtung - ebenfalls flächig ausgeführt. Insbesondere bildet die vordere Abstützung 15 einen Versteifungsring 24 und die hintere Abstützung 16 einen Versteifungsteller 25, von dem - über den Umfang verteilt - eine Vielzahl von Stützarmen 26 ausgehen. Vorzugsweise sind acht Stützarme 26 über den Umfang verteilt vorgesehen. Es können auch mehr oder weniger viele Stützarme 26 vorgesehen sein. Die Prüfmaschine 2 weist zur Aufnahme der Kontakteinrichtung 3 eine Aufnahme 27 auf. Die Stützarme 26 überragen eine Stützfläche 28 der hinteren Abstützung 16 mit Stützarmabschnitten 29, die in randoffenen Schlitzen des Verdrahtungsträgers 10 einliegen. Die randoffenen Schlitze sind aus der Figur 2 aufgrund der gewählten Schnittführung der Querschnittsdarstellung nicht ersichtlich. Die Stützarme 26 sind im Bereich ihrer Stützarmabschnitte 29 mit einem Zwischenbauteil 30 verbunden, das als Zwischenring 31 ausgebildet ist und in der Prüfmaschine 2 positionsgenau befestigt/arretiert werden kann. Hierzu sind entsprechende Kopplungsmittel vorgesehen, die in der Figur 2 jedoch nicht dargestellt sind. Von Bedeutung ist nun, dass die Abstützvorrichtung 14 - wie aus der Figur 2 ersichtlich - mit dem Zwischenbauteil 30 verbunden ist, derart, dass eine permanente Moduleinheit 32 ausgebildet wird, das heißt, dass die Kontakteinrichtung 3 ein eigenes, ihr zugehöriges Zwischenbauteil 30 aufweist, das Zwischenbauteil 30 demzufolge nicht der Prüfmaschine 2 angehört, sondern dass jede in die Prüfmaschine 2 eingesetzte Kontakteinrichtung 3 ein eigenes Zwischenbauteil 30 fest verbunden aufweist, sodass beim Einsetzen der Kontakteinrichtung 3 in die Prüfmaschine 2 keine mechanische Schnittstelle der genannten Art geschlossen werden muss, sondern dass diese Bauteile bereits fest miteinander verbunden sind. Dies kann eine feste solide Verschraubung sein, eine Verklebung 33 wie in der Figur 2 angedeutet, oder aber eine einstückige Ausbildung, die aus der Figur 3 hervorgeht. Während also in der Figur 2 die Abstützvorrichtung 14 zur Bildung eines gemeinsamen Bauteils 34 mit dem Zwischenbauteil 30 verbunden ist, beispielsweise durch die erwähnte Verklebung 33, wobei im dargestellten Fall der Figur 2 die hintere Abstützung 16 mit dem Zwischenbauteil 30 verbunden ist, liegt beim Ausführungsbeispiel der Figur 3 eine Einstückigkeit vor, das heißt, die hintere Abstützung 16 und das Zwischenbauteil 30, das insbesondere als Zwischenring 31 ausgebildet ist, sind einstückig miteinander verbunden. Im letzten Falle wird auf eine Schnittstelle vollkommen verzichtet, sodass insgesamt eine besonders steife Konstruktion vorliegt, sodass beim Kontaktieren des Prüflings keine Verwindungen oder Verformungen auftreten, die die Kontaktierung negativ beeinflussen. Die vordere Abstützung 15 ist mit der hinteren Abstützung 16 über den Verdrahtungsträger 10 durchgreifende Verbindungsmittel (nicht dargestellt) verbunden.

## Patentansprüche

1. Elektrische Kontakteinrichtung für einen elektrischen Prüfling, mit Prüfkontakten zur elektrischen Berührungskontaktierung des Prüflings und mit einer Abstützvorrichtung, der ein Zwischenbauteil zum Halten der Kontakteinrichtung in einer Prüfmaschine (Prober) zuordenbar ist, **dadurch gekennzeichnet, dass** zur Ausbildung einer permanenten Moduleinheit (32) die Abstützvorrichtung (14) mit einem eigenen, nur dieser Kontakteinrichtung (3) zugehörigen Zwischenbauteil (30) verbunden ist.

2. Kontakteinrichtung nach Anspruch 1, **dadurch gekennzeichnet, dass** Abstützvorrichtung (3) und Zwischenbauteil (30) zu einem gemeinsamen Bauteil (34) miteinander verbunden sind.

3. Kontakteinrichtung nach einem der vorhergehenden Ansprüche, **dadurch gekennzeichnet, dass** Abstützvorrichtung (3) und Zwischenbauteil (30) einstückig miteinander verbunden sind.

4. Kontakteinrichtung nach einem der vorhergehenden Ansprüche, **gekennzeichnet durch** die Ausbildung als Prüfkarte (4).

5. Kontakteinrichtung nach einem der vorhergehenden Ansprüche, **dadurch gekennzeichnet, dass** die Prüfkarte (4) als Vertikal-Prüfkarte (5) ausgebildet ist.

6. Kontakteinrichtung nach einem der vorhergehenden Ansprüche, **dadurch gekennzeichnet, dass** zur elektrischen Berührungskontaktierung ein Kontaktkopf (6) vorgesehen ist.

7. Kontakteinrichtung nach einem der vorhergehenden Ansprüche, **dadurch gekennzeichnet, dass** der Kontaktkopf (6) Prüfkontakte (7) aufweist, die als Nadeln, insbesondere Knicknadeln (8), ausgebildet sind.

8. Kontakteinrichtung nach einem der vorhergehenden Ansprüche, **dadurch gekennzeichnet, dass** die Abstützvorrichtung (14) eine vordere Abstützung (15) und eine hintere Abstützung (16) aufweist.

9. Kontakteinrichtung nach einem der vorhergehenden Ansprüche, **dadurch gekennzeichnet, dass** die hintere Abstützung (16) zur Ausbildung der permanenten Moduleinheit (32) mit dem Zwischenbauteil (30) verbunden ist.

10. Kontakteinrichtung nach einem der vorhergehenden Ansprüche, **dadurch gekennzeichnet, dass** zwischen der vorderen Abstützung (15) und der hinteren Abstützung (16) ein Verdrahtungsträger (10), insbesondere eine Leiterplatte (11), angeordnet ist.

11. Kontakteinrichtung nach einem der vorhergehenden Ansprüche, **dadurch gekennzeichnet, dass** Kontakte (12) des Verdrahtungsträgers (10) mit den Prüfkontakten (7) des Kontaktkopfs (6) in Berührungskontakt stehen.

12. Elektrische Prüfvorrichtung für die Prüfung eines elektrischen Prüflings, mit einer Prüfmaschine (Prober), in die jeweils eine der Berührungskontaktierung des Prüflings dienende Kontakteinrichtung, insbesondere nach einem oder mehreren der vorhergehenden Ansprüche, wählbar aus einer Vielzahl von vorzugsweise verschiedenen Kontakteinrichtungen einsetzbar ist, und mit mindestens einem Zwischenbauteil zum Halten der jeweils verwendeten Kontakteinrichtung in der Prüfmaschine, **dadurch gekennzeichnet, dass** jede Kontakteinrichtung (3) mit einem eigenen Zwischenbauteil (30) zur jeweiligen Ausbildung einer permanenten Moduleinheit (32) ausgestattet ist.
